## Europäisches Patentamt

## European Patent Office

## Office européen des brevets

(11) Veröffentlichungsnummer: **0 015 497**
A1

(12) **EUROPÄISCHE PATENTANMELDUNG**

(21) Anmeldenummer: 80100972.1

(22) Anmeldetag: 27.02.80

(51) Int. Cl.³: **H 03 K 17/945,** H 01 H 21/28

(30) Priorität: 08.03.79 DE 2909048

(43) Veröffentlichungstag der Anmeldung: **17.09.80**
**Patentblatt 80/19**

(84) Benannte Vertragsstaaten: **CH IT**

(71) Anmelder: **Gebhard Balluff Fabrik feinmechanischer Erzeugnisse, Gartenstrasse 21, D-7303 Neuhausen a.d.F. (DE)**

(72) Erfinder: **Schmidt, Eberhard, Altdorfer Strasse 20, D-7441 Grossbettlingen (DE)**

(74) Vertreter: **Hoeger, Stellrecht & Partner, Uhlandstrasse 14c, D-7000 Stuttgart 1 (DE)**

(54) **Elektrischer Schalter, dessen Betätigungsseite mehrere Stellungen einnehmen kann.**

(57) Von verschiedenen Seiten her betätigbarer elektrischer Schalter mit einem Trägerteil (10), an dessen einer Frontseite (22) ein Befestigungsteil (12) um eine erste, zur Trägerteil-Frontseite senkrechte Achse (58) drehbar angebracht ist, sowie mit einem der Schalterbetätigung dienenden Steuerteil (14), das am Befestigungsteil (12) um eine zweite Achse (54a) drehbar angebracht ist, welche mit der ersten Achse (58) einen spitzen Winkel bildet.

0015497

A 43 136 b
b - 163
9.Januar 1979

Anmelder: Firma Gebhard Balluff
Fabr.feinmech.Erzeugnisse
Gartenstrasse 21
7303 Neuhausen a.d.F.

·|·  BEZEICHNUNG GEÄNDERT
siehe Titelseite

B e s c h r e i b u n g :

Elektrischer Schalter

Die Erfindung betrifft einen elektrischen Schalter mit einem
Träger- und einem Steuerteil, welchletzteres eine Betätigungsseite aufweist und in mehreren Stellungen derart an der ihm
zugekehrten Frontseite des Trägerteils angebracht werden kann,
dass die Betätigungsseite in einer ersten Stellung vom Trägerteil abgewandt und in weiteren Stellungen mit Seitenflächen
des Trägerteils gleichgerichtet ist, sowie mit einem in einer
Aussparung zwischen Steuer- und Trägerteil angeordneten Befestigungsteil.

Es ist schon ein derartiger, als sogenannter Näherungsschalter
ausgebildeter elektrischer Schalter bekannt geworden, bei dem
die Frontseite des Trägerteils mit einem in der Draufsicht
quadratischen und in den vier Seitenansichten schwalbenschwanzförmigen Ansatz versehen ist, welcher einen zentralen, in das
Innere des Trägerteils führenden Kabelkanal besitzt. Das
Steuerteil weist die Form eines Würfels auf, dessen einer
Kantenbereich derart entfernt wurde, dass sich ein quaderförmiger Ausschnitt mit quadratischem Querschnitt ergibt.
In den Ausschnittflächen und den benachbarten Aussenflächen
befinden sich zwei Ausnehmungen, mit denen das Steuerteil
passend auf den schwalbenschwanzförmigen Ansatz des Trägerteils
aufgeschoben werden kann, worauf das Befestigungsteil in die Aussparung zwischen Steuer- und Trägerteil eingeschoben und
mit Schrauben am Gehäuse des Steuerteils befestigt und dadurch das letztere am Trägerteil gesichert wird. Hinter der
einen, vom Ausschnitt abgewandten Gehäusewand des Steuerteils
befindet sich in einem Gehäusehohlraum eine Spule, über die
der Schalter bei hinreichender Annäherung eines metallischen
Teils berührungslos betätigt wird. Da sich jedoch vom Ausschnitt her Gewindebohrungen für die Befestigung des Befestigungsteils sowie die schwalbenschwanzförmigen Ausnehmungen
in Richtung auf die beiden vom Ausschnitt abgewandten Flächen
des Steuerteils erstrecken, kann das Steuerteil dieses bekannten Schalters nur Spulen aufnehmen, deren Durchmesser
wesentlich kleiner ist als dasjenige Maß, welches sich ergibt,
wenn man von der Kantenlänge des Steuerteils dessen Gehäusewandstärken abzieht. Desweiteren begrenzen die in das Steuerteil hinein vorspringenden schwalbenschwanzförmigen Ausnehmungen und Gewindebohrungen den für die Unterbringung der
notwendigen Elektronik zur Verfügung stehenden Raum. Schliesslich kann bei dem bekannten elektrischen Schalter das Steuerteil nur in 90°-Schritten um die Schalterlängsachse gedreht
werden, so dass nur fünf diskrete Positionen der Betätigungsseite möglich sind (vier Positionen, bei denen die Betätigungsseite nach einer der vier Seiten des Schalters weist, und
eine Position, bei der die Betätigungsseite die eine Stirnseite des Schalters bildet).

Der Erfindung lag die Aufgabe zugrunde, einen Aufbau für einen
Schalter der eingangs erwähnten Art zu finden, der die Möglichkeit eröffnet, die vorstehend erwähnten Nachteile des bekannten Schalters zu vermeiden, und erfindungsgemäss lässt sich diese Aufgabe dadurch lösen, dass das Befestigungsteil
als um eine zur Trägerteil-Frontseite senkrechte erste Achse
drehbares Teil ausgebildet und an der Trägerteil-Frontseite
befestigbar ist und dass das Steuerteil derart umsetzbar am
Befestigungsteil anbringbar ist, dass es um eine zweite, mit
der ersten Achse einen spitzen Winkel bildende Achse drehbar
ist. Durch Drehen des Steuerteils um 180$^{o}$ um die zweite Achse
lässt sich die Betätigungsseite von der einen Stirnseite des
elektrischen Schalters auf eine seiner benachbarten Seiten
bringen, während durch Drehen des Befestigungsteils um die
erste Achse jede beliebige Position der Betätigungsseite um
die erste Achse herum erzielbar ist. Bei dem erfindungsgemässen elektrischen Schalter kann der Gehäusehohlraum des
Steuerteils im Prinzip dessen gesamtes Inneres einnehmen,
da nichts den schwalbenschwanzförmigen Ausnehmungen des
Steuerteils des bekannten Schalters entsprechendes erforderlich ist, und infolgedessen steht der Raum hinter den von
der Aussparung abgekehrten Flächen des Steuerteils bis auf
die Höhe der Aussparung voll für im Steuerteil unterzubringende Elemente zur Verfügung.

Es versteht sich von selbst, dass der elektrische Schalter
nicht unbedingt Quaderform haben muss, auch wenn er vorzugsweise die Form und Abmessungen der Grenztaster nach DIN
43 694 besitzt. Ferner muss das Befestigungsteil nicht um
die erste Achse drehbar sein, solange es sich am Trägerteil
befindet; es könnte ja von letzterem abgenommen, gedreht und
dann wieder am Trägerteil angebracht werden. Auch muss das
Befestigungsteil nicht stetig drehbar sein, sondern die Konstruktion könnte so ausgebildet werden, dass es lediglich diskrete Winkelstellungen bezüglich der ersten Achse einnehmen
kann. Entsprechendes gilt für das Steuerteil, welches vorzugsweise so ausgebildet wird, dass es vom Befestigungsteil gelöst, dann durch Drehen um die zweite Achse umgesetzt und
schliesslich wieder am Befestigungsteil angebracht wird.

Eine besonders einfache und raumsparende Art der Befestigung
des Steuerteils ergibt sich dann, wenn das Befestigungsteil
eine in der zweiten Achse liegende Schraube hält, welche in
ein schräg zur Betätigungsseite verlaufendes Muttergewinde
des Steuerteils einschraubbar ist. Man kommt dann mit einer
einzigen Schraube aus, das Muttergewinde beeinträchtigt die
Unterbringung von Bauteilen im Steuerteil sogut wie nicht
und die Schraube ist leicht zugänglich, ohne dass man hierzu
das Befestigungsteil vom Trägerteil lösen muss.

Bei einer bevorzugten Ausführungsform des erfindungsgemässen
Schalters besitzen das Befestigungs- und das Steuerteil zur
zweiten Achse senkrechte Ansetzflächen, wodurch das Steuerteil fest am Befestigungsteil gehalten wird, obwohl nur eine
einzige Schraube Verwendung findet - selbstverständlich müssen
die erwähnten Ansetzflächen keine durchgehende Fläche bilden.

Bevorzugt wird eine Ausführungsform, bei der das am Trägerteil
angebrachte Befestigungsteil gegenüber diesem um mindestens
270$^{o}$ drehbar ist, d.h. bei dem das Befestigungsteil gegenüber
dem Trägerteil gedreht werden kann, ohne dass es zuvor ganz
abgenommen werden muss. Ein Drehwinkel von 270$^{o}$ ist ausreichend, um die Betätigungsseite des Steuerteils nach allen vier
Seiten des Trägerteils richten zu können.

Wie bereits erwähnt, lassen sich im Steuerteil des erfindungsgemässen Schalters bei gleichen Aussenabmessungen Spulen
grösseren Durchmessers unterbringen als in dem Steuerteil des
vorstehend beschriebenen bekannten Schalters, was deshalb von
Bedeutung ist, weil sich mit dem Spulendurchmesser der Ansprechabstand eines berührungslos betätigbaren Näherungsschalters vergrössern lässt. In diesem Zusammenhang ist aber
klarzustellen, dass die Erfindung nicht auf Näherungsschalter
begrenzt ist, sondern dass die erfindungsgemässe Gestaltung
der verschiedenen Schalterteile auch dann Vorteile mit sich
bringt, wenn es sich z.B. um einen sogenannten Rollenhebelschalter handelt.

Weitere Merkmale, Vorteile und Einzelheiten der Erfindung
ergeben sich aus den beigefügten Ansprüchen und/oder aus der
nachfolgenden Beschreibung und der in der beigefügten Zeichnung dargestellten bevorzugten Ausführungsform eines erfindungsgemässen Schalters, welcher als Näherungsschalter ausgebildet wurde; es zeigen:

Fig. 1      eine schaubildliche Darstellung des Schalters
            bei abgenommenem Steuerteil;

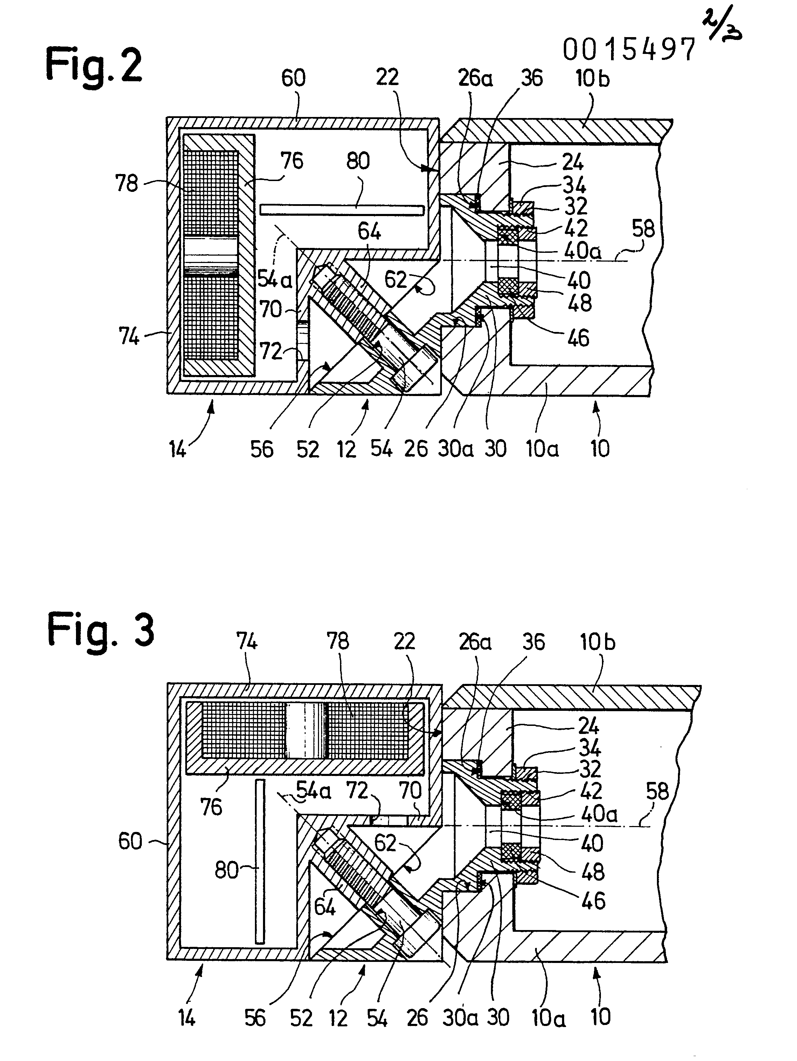

Fig. 2      einen Schnitt durch den vorderen Teil des Trägerteils sowie durch Befestigungs- und Steuerteil,
            wobei der letztere eine erste Position einnimmt,
            bei der seine Betätigungsseite die Stirnseite des
            Schalters bildet;

Fig. 3      einen der Fig. 2 entsprechenden Schnitt, wobei jedoch das Steuerteil umgesetzt wurde, so dass seine Betätigungsseite mit einer der Seitenflächen des
Trägerteils fluchtet, und

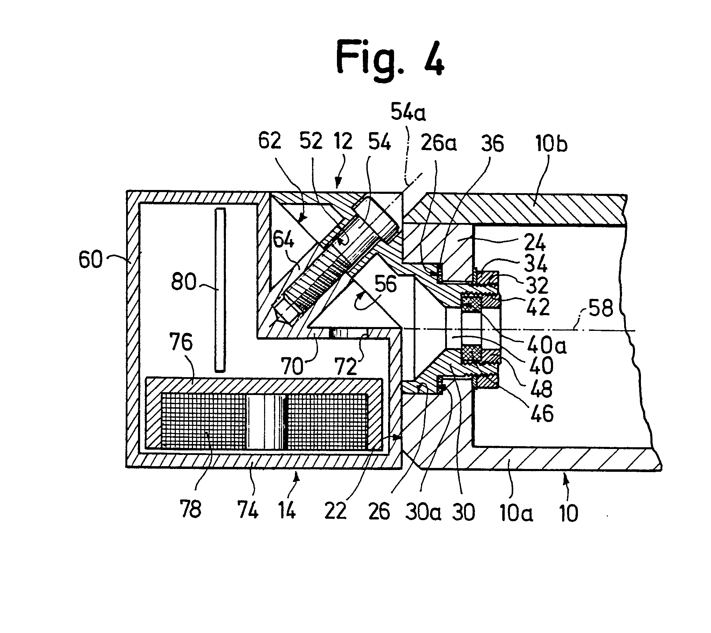

Fig. 4       eine der Fig. 3 entsprechende Darstellung, wobei
jedoch das Steuerteil gegenüber der in Fig. 3
gezeigten Position um die Schalterlängsachse
gedreht wurde.

Der dargestellte elektrische Schalter besitzt ein Trägerteil
10 mit einem eine Wanne 10a und einen Deckel 10b bildenden
Gehäuse, ein Befestigungsteil 12 und ein Steuerteil 14. Der
Deckel 10b des Trägerteils 10 ist in nicht näher dargestellter
Weise an der Wanne 10a befestigt, welche eine eine Frontseite
22 bildende Stirnwand 24 mit einer abgestuften Bohrung 26
aufweist. Die von letzterer gebildete Schulter wurde mit 26a
bezeichnet.

Das Befestigungsteil 12 weist ungefähr Giebeldachform auf
und ist mit einem abgestuften, zapfenförmigen Ansatz 30 versehen, welcher passend in die Bohrung 26 des Trägerteils 10
eingesetzt und in dieser kontinuierlich über 360° gedreht
werden kann; die durch die Abstufung des Ansatzes gebildete
Schulter wurde mit 30a bezeichnet. An seinem dem Innern des
Trägerteils 10 zugewandten Ende besitzt der Ansatz 30 ein
Aussengewinde 32, auf welches eine Spannmutter 34 aufgeschraubt
werden kann. Auf diese Weise lässt sich nicht nur das Befestigungsteil 12 gegenüber dem Trägerteil 10 festlegen, sondern
es kann auch noch ein elastomerer Dichtring 36 zwischen den
Schultern 26a und 30a zusammengepresst werden, um an dieser
Stelle den Innenraum des Trägerteils 10 abdichten zu können.

Der Ansatz 30 besitzt aber auch einen zentralen Kabelkanal
40, und um eine Leckstelle an der Kabeldurchführung zu vermeiden, ist der Kabelkanal abgestuft, so dass er eine Schulter
40a bildet, und ausserdem ist am trägerteilseitigen Ende des
Kabelkanals ein Innengewinde 42 vorgesehen, so dass sich ein
elastomerer Kabeldichtring 46 mittels einer in das Innengewinde 42 eingeschraubten Druckringschraube 48 so verformen
lässt, dass er in radialer Richtung gegen das nicht gezeigte
Kabel abdichtend angepresst wird.

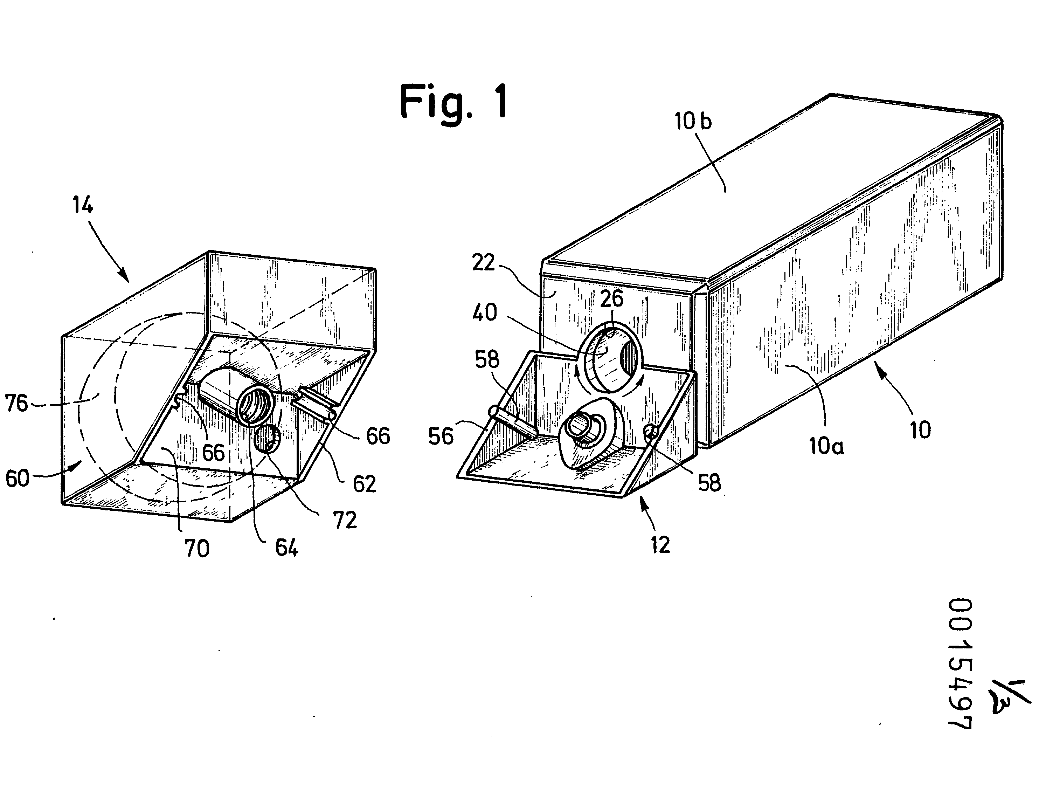

Der in der Seitenansicht dreieckige Bereich des Befestigungsteils 12 besitzt eine Führung 52 für eine Imbusschraube 54,
welche sich senkrecht zu einer in Fig. 1 mit 56 bezeichneten
Ansetzfläche des Befestigungsteils und unter 45° zu der mit
58 bezeichneten Achse des Ansatzes 30 bzw. der Bohrung 26
erstreckt. Die Achse der Schraube 54 wurde 54a bezeichnet.
Ferner sind an das Befestigungsteil 12 stiftförmige Führungsansätze 58 angeformt.

Das Steuerteil 14 besässe Quaderform, wäre nicht ein Kantenbereich mit einem giebeldachförmigen Teilstück abgenommen
worden. Dadurch ergab sich am Gehäuse 60 des Steuerteils 14
eine Ansetzfläche 62, deren Lage und Form derjenigen der
Ansetzfläche 56 des Befestigungsteils 12 entspricht. Erfindungsgemäss definieren beide Ansetzflächen ein Quadrat. An
das Gehäuse 60 sind eine Gewindebuchse 64 für die Schraube
54 und Führungen 66 für die Führungsansätze 58 angeformt, und
ausserdem weist das Gehäuse 60 im Bereich einer dem Befestigungs
teil 12 zugekehrten Wand 70 ein Loch 72 auf, durch welches ein
Kabel aus dem Gehäuseinnenraum des Steuerteils 14 herausgeführt werden kann; dieses Kabel wird dann durch das Befestigungsteil 12 und den Kabelkanal 40 hindurch in das Innere des Trägerteils 10 geführt.

Hinter der mit 74 bezeichneten Wand des Gehäuses 60 des Steuerteils 14 befindet sich eine in einem sogenannten Topfkern 76 untergebrachte Spule 78, so dass die Wand 74 die Betätigungsseite des Steuerteils 14 bildet. Erfindungsgemäss kann der Topfkern 76 einen Durchmesser haben, welcher der Kantenlänge des Gehäuses 60 des Steuerteils 14 abzüglich der doppelten Gehäusewandstärke entspricht. Ferner befindet sich erfindungsgemäss hinter der Spule 78 und dem Topfkern 76 eine Platine 80, die sich ungefähr senkrecht zur Wand 74 erstreckt, und schliesslich ist der Innenraum des Gehäuses 60 erfindungsgemäss mit einem Harz ausgegossen (nicht dargestellt); das Ausgiessen erfolgt, nachdem der Topfkern 76 mit Spule 78 und die Platine 80 im Gehäuse 60 untergebracht wurden und das nicht dargestellte Kabel aus dem Loch 72 herausgeführt wurde - selbstverständlich muss eine der Wände des Gehäuses 60 ursprünglich ein separates Teil gebildet haben, um die Spule und die Platine einbauen zu können.

Um definierte Positionen des Steuerteils 14 bezüglich des Drehwinkels um die Achse 58 festlegen zu können, können Rastmittel vorgesehen sein, z.B. in Form von kleinen Warzen und entsprechenden Vertiefungen an den einander zugekehrten Flächen von Steuerteil 14 und Stirnwand 24.

A 43 136 b
b - 163
9.Januar 1979

Anmelder: Firma Gebhard Balluff
Fabr.feinmech.Erzeugnisse
Gartenstrasse 21
7303 Neuhausen a.d.F.

A n s p r ü c h e :

1.  Elektrischer Schalter mit einem Träger- und einem
Steuerteil, welchletzteres eine Betätigungsseite aufweist und in mehreren Stellungen derart an der ihm
zugekehrten Frontseite des Trägerteils anbringbar ist,
dass die Betätigungsseite in einer ersten Stellung
vom Trägerteil abgewandt und in weiteren Stellungen
mit Seitenflächen des Trägerteils gleichgerichtet ist,
sowie mit einem in einer Aussparung zwischen Steuer-
und Trägerteil angeordneten Befestigungsteil, dadurch
gekennzeichnet, dass das Befestigungsteil (12) als um
eine zur Trägerteil-Frontseite (22) senkrechte erste
Achse (58) drehbares Teil ausgebildet und an der Trägerteil-Frontseite befestigbar ist, und dass das Steuerteil
(14) derart umsetzbar am Befestigungsteil (12) anbringbar ist, dass es um eine zweite, mit der ersten Achse
(58) einen spitzen Winkel bildende Achse (54a) drehbar
ist.

2.  Schalter nach Anspruch 1, dadurch gekennzeichnet, dass
die zweite Achse (54a) gegenüber der ersten Achse (58)
um 45° geneigt ist.

3.  Schalter nach Anspruch 1 oder 2, dadurch gekennzeichnet,
dass das Befestigungsteil (12) eine in der zweiten
Achse (54a) liegende Schraube (54) hält, welche in ein
schräg zur Betätigungsseite (74) verlaufendes Muttergewinde (64) des Steuerteils (14) einschraubbar ist.

4.   Schalter nach einem oder mehreren der vorstehenden Ansprüche, dadurch gekennzeichnet, dass das Befestigungsteil und das Steuerteil zur zweiten Achse senkrechte
     Ansetzflächen (56,62) aufweisen.

5.   Schalter nach einem oder mehreren der vorstehenden Ansprüche, dadurch gekennzeichnet, dass das am Trägerteil
     angebrachte Befestigungsteil gegenüber diesem um mindestens 270° drehbar ist.

6.   Schalter nach einem oder mehreren der vorstehenden Ansprüche, dadurch gekennzeichnet, dass das Befestigungsteil einen zapfenförmigen, sich in Richtung der ersten
     Achse erstreckenden Ansatz (30) besitzt und mit diesem
     in eine Öffnung (26) der Trägerteil-Frontseite (22)
     einsetzbar ist.

7.   Schalter nach Anspruch 6, dadurch gekennzeichnet, dass
     der Ansatz ein Aussengewinde (32) aufweist, auf das
     eine gegen die Innenseite der Trägerteil-Frontwand
     anziehbare Spannmutter (34) aufschraubbar ist.

8.   Schalter nach Anspruch 6 oder 7, dadurch gekennzeichnet, dass der Ansatz eine dem Trägerteil zugekehrte
     Dichtschulter (30a) und die Trägerteil-Frontwand eine
     entsprechend abgestufte Öffnung (26) aufweist.

9.   Schalter nach einem oder mehreren der Ansprüche 6 bis 8,
     dadurch gekennzeichnet, dass der Ansatz einen Kabelkanal
     (40) aufweist.

10.  Schalter nach Anspruch 9, dadurch gekennzeichnet, dass
     der Kabelkanal abgestuft ist und ein Innengewinde (42)
     für eine Druckringschraube (48) aufweist, zwischen der
     und einer von der Kabelkanalwand gebildeten Schulter
     (40a) ein elastomerer Kabeldichtring (46) einspannbar
     ist.

11.  Schalter nach einem oder mehreren der vorstehenden Ansprüche, dadurch gekennzeichnet, dass das Steuerteil
     einen von einer Gehäusewand umschlossenen Hohlraum
     aufweist, dessen Abmessungen hinter dem auf der Betätigungsseite liegenden Gehäusewandbereich (74) den um
     die Gehäusewanddicken verminderten Aussenabmessungen
     des Steuerteils entsprechen.

12.  Schalter nach einem oder mehreren der vorstehenden Ansprüche, dadurch gekennzeichnet, dass das Steuerteil
     (14) die Form eines Würfels aufweist, dessen einer
     Kantenbereich längs einer Ebene abgetrennt ist, welche
     mit den benachbarten Kanten Winkel von 45° bildet.

13.  Schalter nach Anspruch 11 oder 12, dadurch gekennzeichnet, dass der Gehäusehohlraum des Steuerteils hinter
     dessen die Betätigungsseite bildenden Gehäusewandbereich
     (74) eine Spule (78) und hinter dieser aussermittig
     eine zu diesem Gehäusewandbereich ungefähr senkrecht
     verlaufende Platine (80) mit Elektronikbauteilen aufnimmt.

14.    Schalter nach einem oder mehreren der vorstehenden Ansprüche, dadurch gekennzeichnet, dass Steuerteil (14)
       und Befestigungsteil (12) zusammen einen Würfel bilden,
       dessen Kantenlänge derjenigen der Stirnseite eines
       Grenztasters nach DIN 43 694 entspricht.

Fig. 1

Firma Gebhard Balluff, Fabrik feinmech. Erzeugnisse, Gartenstr. 21, 7303 Neuhausen a.d. F.

Blatt 1
Blatt

HÖGER - STELLRECHT - GRIESSBACH - HAECKER A 43 136
PATENTANWÄLTE IN STUTTGART

**Fig.2**

**Fig. 3**

A 43 136 t

# Fig. 4

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | <u>DE - B - 2 713 213</u> (BUCK) <br> * Figuren 1-3; Spalte 3, Zeile 62 bis Spalte 5 * <br><br> -- | 1-5,9, 13 |
| | <u>DE - A - 2 622 563</u> (KLASCHKA) <br> * Figur 5; Seite 6, Zeile 12 bis Seite 8, Zeile 16 * <br><br> -- | 1,5,7, 9,11- 13 |
| A | <u>FR - A - 2 393 473</u> (BUCK) <br><br> ---- | 1 |

### KLASSIFIKATION DER ANMELDUNG (Int.Cl. 3)

H 03 K 17/945
H 01 H 21/28

### RECHERCHIERTE SACHGEBIETE (Int. Cl. 3)

H 03 K 17/945
     17/95
     17/94
     17/955
H 01 H 21/28
     21/34
     36/00

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 14-05-1980 | LEDRUT |

EPA form 1503.1   06.78